# EUROPEAN PATENT SPECIFICATION

(11) **EP 4 109 762 B1**
(45) Date of publication and mention of the grant of the patent: **18.11.2026**
(21) Application number: 22175844.4
(22) Date of filing: 27.05.2022
(51) Int. Cl.: H03M 3/02, G06G 7/19, H03H 17/00, H03M 7/32

(54) **SYSTEM AND METHOD OF CALIBRATION OF SIGMA-DELTA CONVERTER USING INJECTED SIGNAL CORRELATION**
SYSTEM UND VERFAHREN ZUR KALIBRIERUNG EINES SIGMA-DELTA-WANDLERS UNTER VERWENDUNG EINER INJIZIERTEN SIGNALKORRELATION
SYSTÈME ET PROCÉDÉ D'ÉTALONNAGE D'UN CONVERTISSEUR SIGMA-DELTA À L'AIDE D'UNE CORRÉLATION DES SIGNAUX INJECTÉS

(30) Priority: 24.06.2021 US 202117357467
(43) Date of publication of application: 28.12.2022
(73) Proprietor: NXP B.V., 5656 AG Eindhoven (NL)
(72) Inventor: Rutten, Robert, 5656 AG Eindhoven (NL); van der Ploeg, Hendrik, 5656 AG Eindhoven (NL); Breems, Lucien Johannes, 5656 AG Eindhoven (NL); Kessel, Martin, 5656 AG Eindhoven (NL); Bolatkale, Muhammed, 5656 AG Eindhoven (NL); Burdiek, Bernhard, 5656 AG Eindhoven (NL); Zupke, Manfred, 5656 AG Eindhoven (NL); Brekelmans, Johannes Hubertus Antonius, 5656 AG Eindhoven (NL); Bajoria, Shagun, 5656 AG Eindhoven (NL)
(74) Representative: Schmütz, Christian Klaus Johannes

(56) References cited:
- US-B1- 7 042 375
- US-B2- 7 324 028
- US-B2- 9 838 031
- AHMED ASHRY ET AL: "Main defects of LC-based [Sigma][Delta] modulators", CIRCUITS AND SYSTEMS (MWSCAS), 2010 53RD IEEE INTERNATIONAL MIDWEST SYMPOSIUM ON, IEEE, PISCATAWAY, NJ, USA, 16 August 2010 (2010-08-16), pages 897 - 900, XP031732771, ISBN: 978-1-4244-7771-5

## Description

### BACKGROUND

### FIELD OF THE INVENTION

The present invention relates in general to calibrating a sigma-delta converter, and more particularly to a system and method of calibrating a sigma-delta converter using injected signal correlation.

### DESCRIPTION OF THE RELATED ART

In higher order sigma-delta converters including sigma-delta analog to digital converters (ADCs) and the like, resonators are typically used to get a better signal to quantization noise ratio (SQNR) in the band of interest (BoI). The resonator frequencies are determined by the loop filter in the ADC design. Typically, the resonator frequencies are set by passive devices such as a combination of resistors and capacitors. The resonator frequencies determine the level of the quantization noise in the BoI. The elements setting these resonator frequencies suffer, however, from manufacturing variation and temperature dependency. If the quantization noise is a significant contributor to the total noise performance, the resonator frequencies need to be calibrated and require tracking over temperature variation.

From US 7 042 375 B1 a system and method using dither to tune a filter is known.

From Ahmed Ashry et al., "Main Defects of LC-Based ΣΔ Modulators", Circuits and Systems (MWSCAS), 2010 53rd IEEE International Midwest Symposium on, 1 August 2010, pages 897-900), main defects of LC-based ΣΔ modulators due to process variations are known.

From US 7 324 028 B2 a self-calibrating continuous-time delta-sigma modulator is known.

From US 9 838 031 B2 dither injection for continuous-time mash ADCs is known.

### BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.
FIG. 1 is a simplified block diagram of a digital conversion system including calibration circuitry implemented according to an embodiment of the present disclosure.
FIG. 2 shows a pair of graphic diagrams plotting the magnitude (M) and phase (PH) versus frequency of a transfer function H_{PY} from the PRBS signal to the output DOUT of the sigma-delta ADC of FIG. 1 according to one embodiment of the present disclosure.
FIG. 3 is a graphic diagram plotting the output spectrum of DOUT (shown as signal power measured in dB) versus frequency for the sigma-delta ADC of FIG. 1 using an input signal AIN at an input frequency F_{IN} according to one embodiment of the present disclosure.
FIG. 4 is a simplified block diagram of the digital conversion system of FIG. 1 including further details of the calibration circuitry implemented according to an embodiment of the present disclosure.
FIG. 5 is a simplified block diagram of the correlator of FIG. 4 implemented according to one embodiment of the present disclosure.
FIG. 6 is a simplified block diagram of the loop controller of FIG. 4 implemented according to one embodiment of the present disclosure.
FIG. 7 is a simplified block diagram of the loop controller of FIG. 4 implemented according to another embodiment of the present disclosure.
FIG. 8 is a graphic diagram plotting signal power of DOUT at the output of the sigma-delta ADC of FIG. 1 versus frequency for three separate resonant frequencies of the loop filter superimposed with a passband amplitude transfer function of the bandpass filters of FIG. 4 according to one embodiment of the present disclosure.
FIG. 9 is a graphic diagram plotting a normalized version of a real portion of the ERR signal versus frequency for a simulation of 11 notch frequency between F_{L} and F_{U} of the loop filter of FIG. 1 according to one embodiment of the present disclosure.
FIG. 10 is a graphic diagram plotting the COR signal as a correction code versus time for a closed-loop simulation of the analog to digital conversion system of FIG. 1 according to one embodiment of the present disclosure.
FIG. 11 is a schematic diagram of the integrator implemented according to one embodiment of the present disclosure that may be used as either or both of the integrators within the loop filter of FIG. 1.
FIG. 12 is a schematic diagram of the integrator implemented according to another embodiment of the present disclosure that may be used as either or both of the integrators within the loop filter of FIG. 1.
FIG. 13 is a simplified block diagram of an alternative bandpass filter that may be used instead of each of the bandpass filters of FIG. 4 according to one embodiment of the present disclosure.
FIG. 14 is a simplified block diagram of an injection signal generator generating an injection signal IS that is injected into the sigma delta ADC of FIG. 1 according to another embodiment of the present disclosure.

### DETAILED DESCRIPTION

A system and method of calibration of a sigma-delta converter as described herein uses correlation between an output of the converter and an injected signal to find an optimal resonator frequency in the ADC. Pseudo Random Bit Stream (PRBS) signal injection is a known way to improve the performance of a sigma-delta converter in which a PRBS dither signal is typically injected at the input of a quantizer of the converter. Thus, the PRBS signal, if used, provides a conveniently available injected signal for use in calibration. If PRBS is not used or otherwise not provided, a separate signal may be generated and injected into the converter. The injected signal has frequency-symmetrical power around a target notch frequency within a selected frequency passband centered at the target notch frequency. The symmetry need not be perfect so long as substantially symmetrical for calibration to be sufficiently successful. In one embodiment, the injected signal may be randomized, such as a pseudo-random signal. In another embodiment, the injected signal may be a dual tone signal positioned on either side of the target notch frequency. The injected signal and output signal are both filtered with a corresponding one of a pair of bandpass filters, each bandpass filter having a passband with a center frequency at the target notch frequency of the output signal of the converter. The invention is as defined in independent claims 1 and 11. Dependent claims 2 to 10 define particular embodiments of the invention.

It is noted that the resonator frequency of a loop filter of the sigma-delta converter results in a corresponding notch frequency at the output of the sigma-delta converter. The injected signal is substantially symmetrical around a target notch frequency within a selected frequency passband centered at the target notch frequency (e.g., pseudo-random signal, dual tone signal, etc.). Theoretically, there is a 180 degrees phase shift of the injected signal modulated in the converter output, so that the correlation between the two bandpass filtered signals is zero or substantially near zero when the notch frequency is at the target location. Calibration circuitry monitors the correlation result and adapts the resonant frequency of the loop filter to adjust the ADC notch frequency accordingly in a calibration loop.

The calibration of the present system and method converges relatively quickly when the sigma-delta converter is off-line and not processing an input signal. The calibration of the present system and method may be used for background calibration when an input signal is applied, although convergence becomes slower. The present system and method is thus particularly advantageous for start-up or periodic off-line calibration, and is also useful for background calibration in the presence of an input signal when slower calibration may be tolerated.

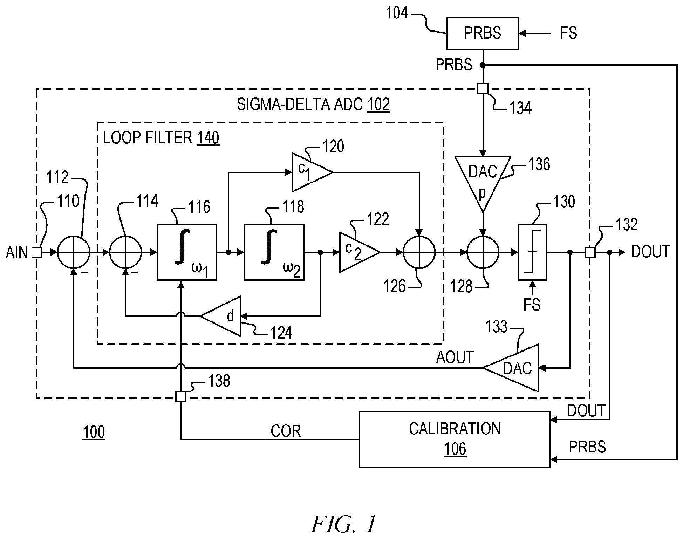

FIG. 1 is a simplified block diagram of a digital conversion system 100 including calibration circuitry 106 implemented according to an embodiment of the present disclosure. In the illustrated embodiment, the digital conversion system 100 includes a sigma-delta analog to digital converter (ADC) 102 receiving a PRBS dither signal from a PRBS generator 104, and also includes the calibration circuitry 106 for calibrating the sigma-delta ADC 102. In the illustrated embodiment, the sigma-delta ADC 102 includes a loop filter 140 that determines at least one resonator frequency used to get a better signal to quantization noise ratio (SQNR) in the band of interest (BoI) of the sigma-delta ADC 102. In general, the resonator frequencies of a converter determine the level of the quantization noise in the BoI. The elements setting these resonator frequencies suffer, however, from manufacturing variation and temperature dependency. Such elements may include any combination of passive elements (e.g., resistors, capacitors, inductors) and active elements (e.g., transistors and the like). If the quantization noise is a significant contributor to the total noise performance, each resonator frequency should be calibrated and tracked over temperature.

An analog input signal AIN is provided to an analog input 110 of the sigma-delta ADC 102, in which AIN is provided to a positive input of an adder 112. It is noted that although the conversion system is illustrated by an ADC, the input signal AIN may alternatively be a digital signal. The output of the adder 112 is provided to a positive input of another adder 114, having its output coupled to an input of an integrator 116 with radian frequency ω₁. The output of the integrator 116 is coupled to an input of another integrator 118 with radian frequency ω₂ and to an input of an amplifier 120 with a gain of c₁. It is noted that ω₁ and ω₂ may be referred to as the gains of the integrators 116 and 118, respectively. The output of the integrator 118 is coupled to an input of an amplifier 122 with a gain of c₂ and to an input of another amplifier 124 with a gain of d. The output of the amplifier 124 is provided to a negative input of the adder 114. The outputs of the amplifiers 120 and 122 are provided to respective positive inputs of an adder 126, having its output coupled to a positive input of another adder 128. The output of the adder 128 is coupled to the input of a quantizer 130, having its output providing a digital output signal DOUT provided via an ADC output 132.

In one embodiment, DOUT is a single-bit output, such as a series of 1's and 0's or the like. In another embodiment, DOUT may be a multibit value. DOUT is fed back to an input of a digital to analog converter (DAC) 133 having an output providing an analog output signal AOUT (an analog version of DOUT) provided to a negative input of the adder 112. The adders 112 and 114 may alternatively be referred to as subtractors in which adder 112 develops its output by subtracting AOUT from AIN and the adder 114 develops its output by subtracting the output of the amplifier 124 from the output of the adder 112. The adders 120 and 126 add their respective inputs to develop their outputs in the illustrated configuration.

In alternative embodiments, AIN may be a digital signal in which the DAC 133 may be omitted or replaced by a digital-to-digital converter or amplifier. The sigma-delta ADC 102 is an example of a sigma-delta system implemented according to a 2^{nd} order feedforward architecture. The present system and method of calibration as described herein may be applied to other structures or architectures, such as feedback architectures, combined feedback/feedforward architectures, and higher order configurations (e.g., 3^{rd} order, 4^{th} order, etc.) and the like.

The PRBS signal from the PRBS generator 104 is provided to an injection input 134 of the sigma-delta ADC 102, in which the PRBS signal is provided to an input of a digital to analog converter (DAC) 136 having a gain of p. The output of the DAC 136 is provided to another positive input of the adder 128, which provides the sum of the outputs of the adder 126 and the DAC 128 to the input of the quantizer 130. The DOUT and PRBS signals are provided to respective inputs of the calibration circuitry 106, having its output providing a correction signal COR to a frequency adjust input 138 of the sigma-delta ADC 102. The adders 114 and 126, the integrators 116 and 118, and the amplifiers 120, 122, and 124 collectively form the loop filter 140 within the sigma-delta ADC 102. The sigma-delta ADC 102 includes the adders 112 and 128, the DACs 133 and 136, the quantizer 130, and the loop filter 140. The PRBS generator 104 and the quantizer 130 both receive a sample signal FS. The COR signal from the calibration circuitry 106 is used to adjust a resonant frequency of the loop filter 140 of the sigma-delta ADC 102 as further described herein. In one embodiment, the COR signal is provided to adjust the gain ω₁ of the integrator 116. In alternative embodiments, COR may be used to adjust other values or parameters, such as c1, c2, d, ω₂, or the like or a combination of such parameters.

In a more particular embodiment, ω₁ = 2.5 Megahertz (MHz), ω₂ = 400 kilohertz (kHz), FS has an oversampling frequency of 100MHz, c₁ = 0.2, c₂ = 0.25, d = 0.05, and p = 0.05. These are approximate values for a particular configuration and alternative values are contemplated for different implementations. In addition, one or more of these parameters are adjusted during calibration to adjust a resonant frequency of the loop filter 140 and hence a notch frequency at the output of the sigma-delta ADC 102. In one embodiment, DOUT is a digital signal having a binary "1" or "0" for a single-bit quantizer 130, and the DAC 133 converts DOUT to AOUT by converting digital input "1" to +1 and digital input "0" to -1.

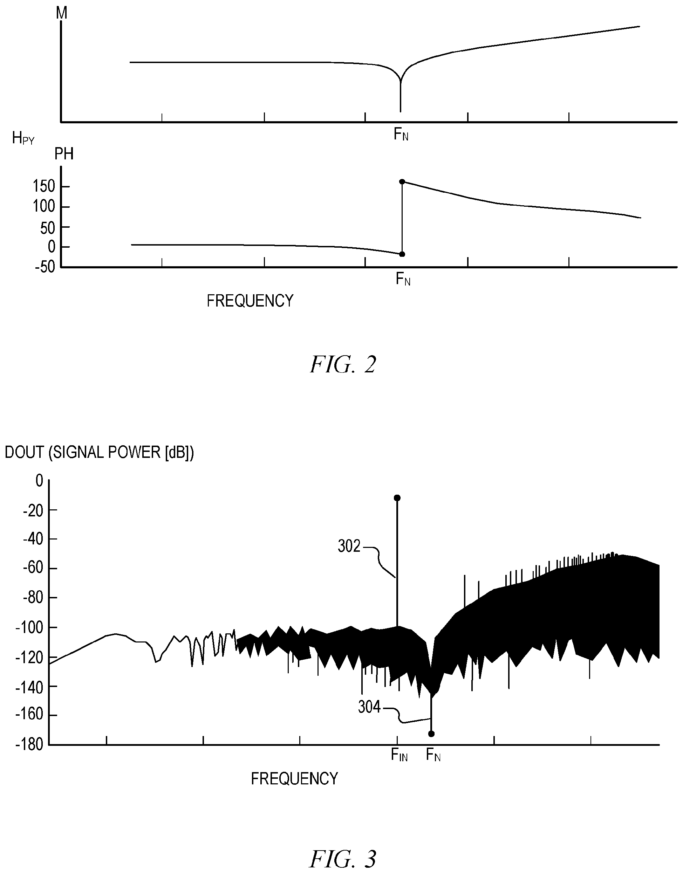

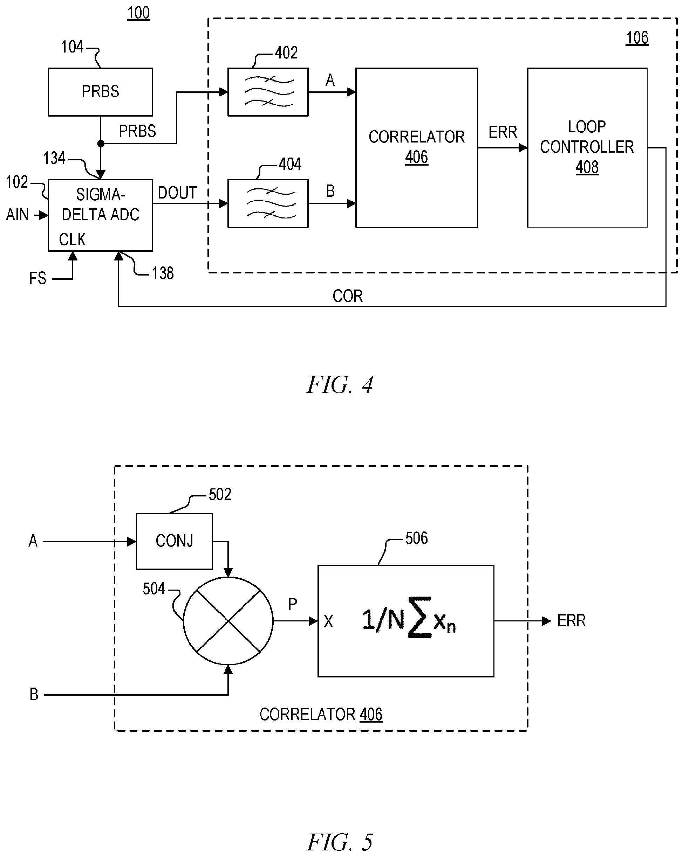

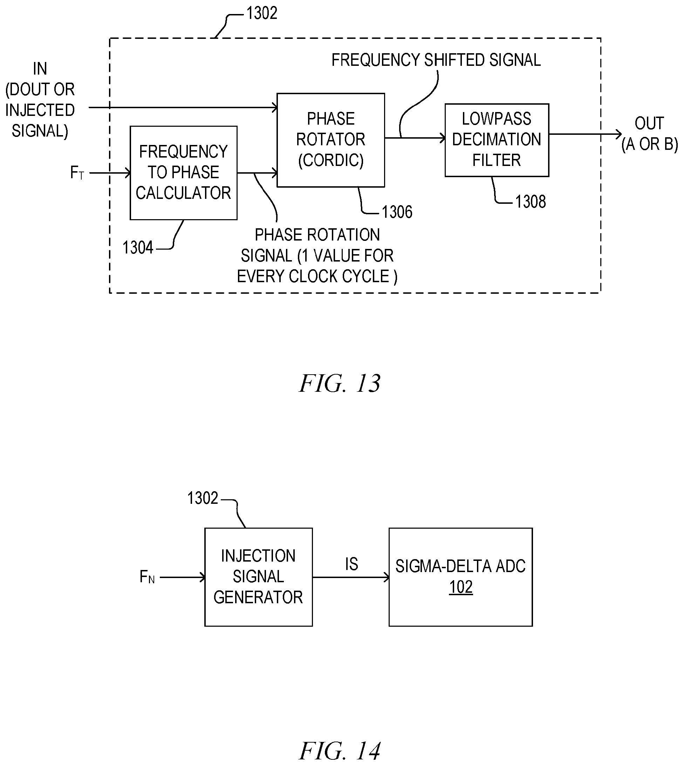

As previously noted, PRBS is a pseudo-random signal that is conveniently available since used as a dither input signal injected at the input of the quantizer 130 to improve performance of the digital conversion system 100. In an alternative configuration, such as when the PRBS is not provided or otherwise not available, then a separate pseudo-random generator (not shown) may be included to generate a pseudo-random signal or at least a signal that is pseudo-random in the passband frequency range of the bandpass filters 402 and 404 (FIG. 4) described further herein. In any of the embodiments, the injected signal is substantially symmetrical with respect to a target notch frequency (see, e.g., FN of FIG. 3) within the passband of the bandpass filters 402 and 404 or of the bandpass filter 1302 (FIG. 13). In another embodiment, for example, the injected signal may be dual tone signal located on either side of the target notch frequency. The dual tone signal may be injected in a similar manner as shown in FIG. 1 using the adder 128 or other signal combiner. The generated signal is injected into the conversion path of the sigma-delta ADC 102 to achieve correlation for purposes of calibration.

FIG. 2 shows a pair of graphic diagrams plotting the magnitude (M) and phase (PH) versus frequency of a transfer function H_{PY} from the PRBS signal to the output DOUT of the sigma-delta ADC 102 according to one embodiment of the present disclosure. The particular units of the magnitude and frequency are not shown, but magnitude is typically measured in decibels (dB) and frequency is typically measured in Hertz (Hz). The units of phase are shown in degrees. The resonant frequency of the loop filter 140 creates a notch (or zero in the zero/pole diagram) at a notch frequency F_{N}. The phase of H_{PY} undergoes an instant 180⁰ phase shift at the notch frequency F_{N}. The transfer function H_{LF} of the loop filter 140 of the sigma-delta ADC 102 is according to the following equation (1): ${H}_{LF} = \frac{{c}_{1} {ω}_{1} s + {c}_{2} {ω}_{1} {ω}_{2}}{{s}^{2} + {ω}_{1} {ω}_{2} d}$ (1) which represents one zero and one complex conjugate pole combination. The transfer function H_{PY} from the PRBS signal to the output DOUT is according to the following equation (2): ${H}_{PY} = \frac{1}{1 + {DAC}_{gain} ∗ {H}_{LF}}$ (2) where DAC_{gain} is the gain of the DAC 133, which is 1 in the illustrated embodiment. H_{PY} may also be referred to as the Noise Transfer Function (NTF) of the sigma-delta ADC 102.

FIG. 3 is a graphic diagram plotting the output spectrum of DOUT (shown roughly as signal power measured in dB) versus frequency for the sigma-delta ADC 102 using an input signal AIN at an input frequency F_{IN} according to one embodiment of the present disclosure. A positive spike 302 occurs coincident with the input signal AIN at F_{IN}, and a notch 304 occurs at about the notch frequency F_{N}. In a non-limiting specific embodiment using the specific radian and gain units previously described along with AIN provided as a 100kHz sine wave (e.g., F_{IN} = 100kHz), the notch 304 occurs at a notch frequency F_{N} of about 223.5kHz.

FIG. 4 is a simplified block diagram of the digital conversion system 100 including further details of the calibration circuitry 106 implemented according to an embodiment of the present disclosure. The calibration circuitry 106 includes a first bandpass filter 402, a second bandpass filter 404, a correlator 406, and a loop controller 408. The PRBS signal from the PRBS generator 104 is provided to an input of the first bandpass filter 402 and the DOUT output of the sigma-delta ADC 102 is provided to an input of the second bandpass filter 404 of the calibration circuitry 106. The outputs of the bandpass filters 402 and 404, shown as signals A and B, respectively, are provided to a respective pair of inputs of the correlator 406, having an output providing an error (ERR) signal to an input of the loop controller 408. The loop controller 408 uses the ERR signal to develop the correction signal COR, which is fed back to the frequency adjust input 138 of the sigma-delta ADC 102. The sigma-delta ADC 102 has a clock input CLK receiving the sample signal FS.

The bandpass filters 402 and 404 are substantially identical and both are implemented with a frequency passband that is centered at the target notch frequency at the output of the sigma-delta ADC 102. The target notch frequency is predetermined based on operating parameters of the sigma-delta ADC 102. The bandpass filters 402 and 404 are each configured as a complex filter having a frequency response that is asymmetrical around 0 Hz. As an example, a complex filter may contain 2 real filters, one for the in-phase (I) path and one for the quadrature (Q) path. In one embodiment, the complex I/Q filter passes only a part of the positive frequency band, attenuating frequencies in the negative frequency domain. A complex I/Q filter can generate a filter response which is asymmetrical around 0 Hz, and can bandpass frequencies in the positive frequency domain while attenuating frequencies in the negative frequency domain. It has been determined that when the resonant frequency of the loop filter 140 is tuned so that the notch at the output of the sigma-delta ADC 102 is at the target notch frequency, the correlation between the PRBS and DOUT signals cancel out or otherwise reach a minimum correlation value, such as zero. If the resonant frequency of the loop filter 140 varies because of manufacturing variations, operating conditions, aging, temperature changes, voltage variations, along with other possible changes and variations, then the resonant frequency is off target so that the actual notch frequency is not aligned with the center frequency of the bandpass filters 402 and 404. As a result, the correlation results are nonzero as reflected by the ERR signal. The loop controller 408 uses negative feedback to provide COR to adjust the resonant frequency of the loop filter 140 and thus the notch frequency at the output of the sigma-delta ADC 102 to minimize the magnitude of ERR. In this manner, the sigma-delta ADC 102 is calibrated.

FIG. 5 is a simplified block diagram of the correlator 406 implemented according to one embodiment of the present disclosure. The correlator 406 includes a complex conjugate block 502, a multiplier 504, and mean calculator 506. The output signal A of the first bandpass filter 402 is provided to an input of the complex conjugate block 502, having an output provided to one input of the multiplier 504. The output signa B of the second bandpass filter 404 is provided to the other input of the multiplier 504, having an output providing a product value P to an input of the mean calculator 506. The mean calculator 506 calculates the mean of the multiplied result to develop the ERR signal. In one embodiment, the mean calculator 506 is a summing and divider block that generates a running average of that last integer number of "N" multiplier output samples, such as accumulating the last N samples into a running sum and dividing the sum by N. The complex conjugate block 502 may be applied to either one of the A and B inputs; essentially, one of the filtered signals is flipped in the frequency domain, so that the product should be zero when the filtered signals are equal or substantially equal.

The correlator 406 comprises the complex conjugate block 502, the multiplier 504 and the mean calculator 506 as described above. In addition, alternative types of summing or integration functions may be used.

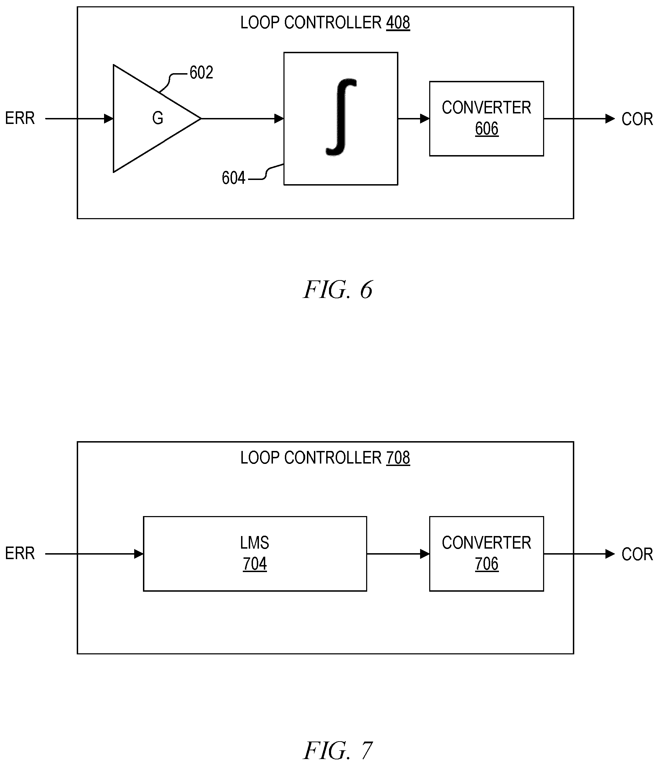

FIG. 6 is a simplified block diagram of the loop controller 408 implemented according to one embodiment of the present disclosure. The loop controller 408 includes an amplifier 602, an integrator 604, and a converter 606. The ERR signal is provided to an input of the amplifier 602, having an output coupled to an input of the integrator 604, having an output coupled to an input of the converter 606, having an output providing the COR signal. The amplifier 602 has a scalar gain G that may be used to adjust the gain of the control loop used for adjusting the resonant frequency of the loop filter 140. The integrator 604 integrates the output of the amplifier 602 for loop control. The converter 606 converts the output of the integrator 604 so that the COR signal has a scale and range suitable for the parameter being adjusted within the sigma-delta ADC 102 to adjust the notch frequency accordingly. In this manner, the COR signal adjusts a parameter within the sigma-delta ADC 102 to adjust the resonant frequency of the loop filter 140, which in turn adjusts the notch frequency to minimize the ERR signal.

The convergence time is dependent on the gain of the control loop as may be controlled by the gain of the amplifier 602. The gain should be chosen such that the loop is sufficiently fast while also being sufficiently stable after settling. The gain value may depend on many parameters including, for example, ADC sampling rate, dither amplitude, potential blocker signals, etc. The control loop works such that after convergence the notch frequency is positioned at a center frequency F_{C} of the bandpass filters 402 and 404 when the spectrum around the target frequency notch is symmetrical.

FIG. 7 is a simplified block diagram of a loop controller 708 implemented according to another embodiment of the present disclosure which may be used as the loop controller 408. The loop controller 708 is substantially similar to the loop controller 408 in which the gain block 602 and the integrator 604 are replaced by an alternative function such as a least-mean square (LMS) block 704 for controlling gain and loop operation. The converter 606 is replaced by a similar converter 706 that performs substantially the same function to convert the output of the LMS block 704 into the COR signal.

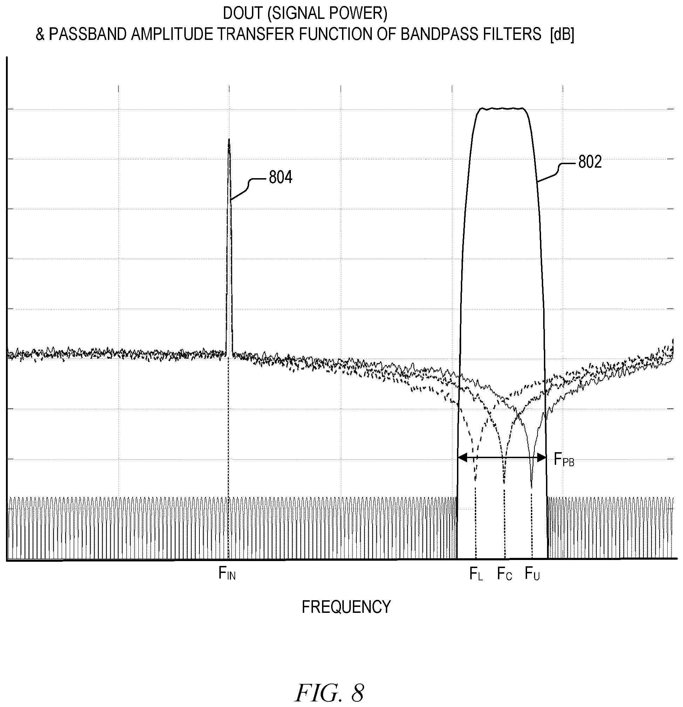

FIG. 8 is a graphic diagram plotting signal power of DOUT at the output of the sigma-delta ADC 102 versus frequency for three separate resonant frequencies of the loop filter 140 superimposed with a passband amplitude transfer function 802 of the bandpass filters 402 and 404 according to one embodiment of the present disclosure. It is noted that the spectra is averaged and the stop-band attenuation of the passband is increased for purposes of illustration. A low resonant frequency corresponds with a low notch frequency F_{L}, an optimum resonant frequency corresponds with a center notch frequency F_{C}, and a high resonant frequency corresponds with an upper notch frequency F_{U}. For simulation operation, the loop controller 408 (or 708 or the like) is disabled or otherwise removed while the frequency adjust input 138 of the sigma-delta ADC 102 is manipulated by test equipment or the like to adjust the resonant frequency of the loop filter 140. The input signal AIN is asserted as a sinusoidal signal with an input frequency F_{IN} as depicted by a spike 804 at F_{IN}. The passband amplitude transfer function 802 is centered at the center frequency F_{C} with a passband frequency range F_{PB} that includes F_{L} and Fu.

FIG. 8 illustrates that adjustment of the resonant frequency of the loop filter 140 adjusts the notch frequency at the output of the sigma-delta ADC 102. The notch frequency may be outside passband frequency range F_{PB} or anywhere within F_{PB} of the bandpass filters 402 and 404, in which adjustment is performed during calibration to move the notch frequency at or as close as possible to the center frequency F_{C}.

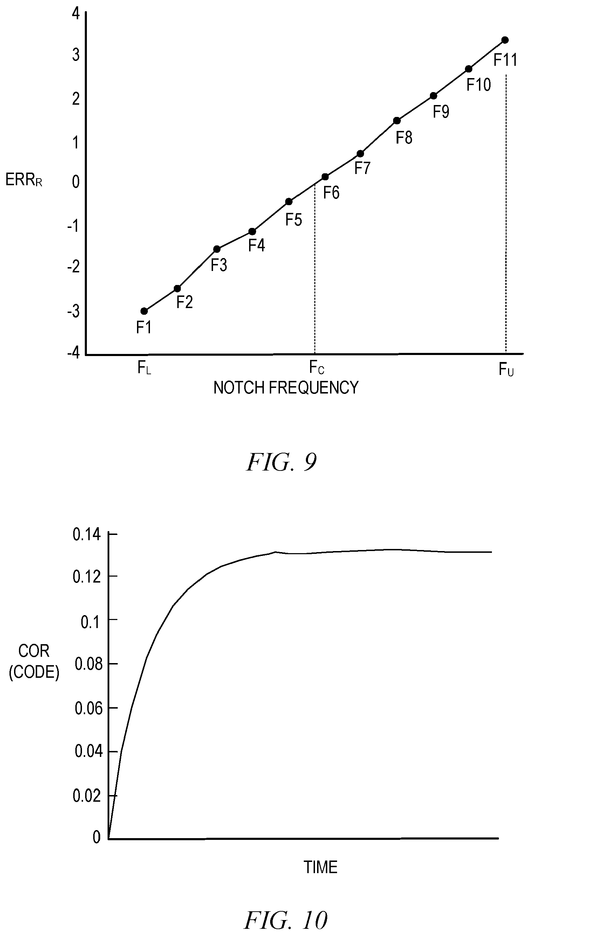

FIG. 9 is a graphic diagram plotting a normalized version of a normalized real portion of the ERR signal, shown as ERR_{R}, versus frequency for a simulation of 11 notch frequency points F1, F2, ..., F11 between F_{L} and F_{U} according to one embodiment of the present disclosure. The actual units and range of ERR and ERR_{R} depend upon various factors, such as the NTF of the sigma-delta ADC 102 and the dither gain controlled by the gain p of the DAC 136 among other factors. The resonant frequency of the loop filter 104 is adjusted so that the notch frequency is incremented by F_{PB}/10 from F_{L} to F_{U}. For each of the 11 frequency points, the real portion ERR_{R} of the ERR signal between the bandpass filtered PRBS signal (or other injected signal) and the bandpass filtered output of the sigma-delta ADC 102 is calculated. As shown, ERR_{R} varies linearly with respect to the notch frequency from about -3 for F_{L} and the lower frequency end to about +3.5 for F_{U} at the upper frequency end of the frequency passband F_{PB} of the bandpass filters. The value of ERR_{R} is zero or near zero at the center frequency F_{C} of the passband which is the target notch frequency. The loop controller 408 thus controls or otherwise adjusts COR during calibration by increasing the resonant frequency of the loop filter 140 when ERR_{R} is negative and decreasing the resonant frequency of the loop filter 140 when ERR_{R} is positive until ERR_{R} is at or near zero or otherwise minimized.

FIG. 10 is a graphic diagram plotting the COR signal as a normalized correction code versus time for a closed-loop simulation of the digital conversion system 100 according to one embodiment of the present disclosure. Although not specifically shown, the notch frequency is initially set at a low value, such as at or near F_{L}. As shown, COR increases and ultimately settles on a suitable value when the notch frequency reaches F_{C}. The correction code may be used to modify passive devices such as resistance(s) of at least one adjustable resistor, capacitance(s) of at least one adjustable capacitor, inductance(s) of at least one adjustable inductor of the loop filter 140 to adjust its resonant frequency and thus the output notch frequency. It is also contemplated that active devices such as transistors or the like may be adjusted, such as digitally selecting from among multiple devices coupled in parallel.

The convergence time is dependent on the gain of the control loop which can be adjusted by adjusting the gain of the amplifier 602 in the loop controller 408 or the gain of the LMS block 704 of the loop controller 708. The gain should be chosen such that the loop is fast enough, but after settling it should be sufficiently stable. The gain value depends on a lot of parameters like sampling rate, injected signal or dither amplitude and potential blocker signals. The control loop works such that after convergence the notch frequency is positioned in the middle of the bandpass filter transfer when the spectrum around the notch is symmetrical. The bandpass filter may be a digital filter, which can be centered around any frequency depending on its filter coefficients. The bandpass filter may also be constructed by a frequency shift (e.g., using a cordic or the like) in combination with a low-pass (decimation) filter, such as shown in FIG. 13 described further herein. The advantage of this approach is that the center frequency of the filter can be adapted with the cordic mixing frequency, and the signal processing frequency goes down when decimation is used.

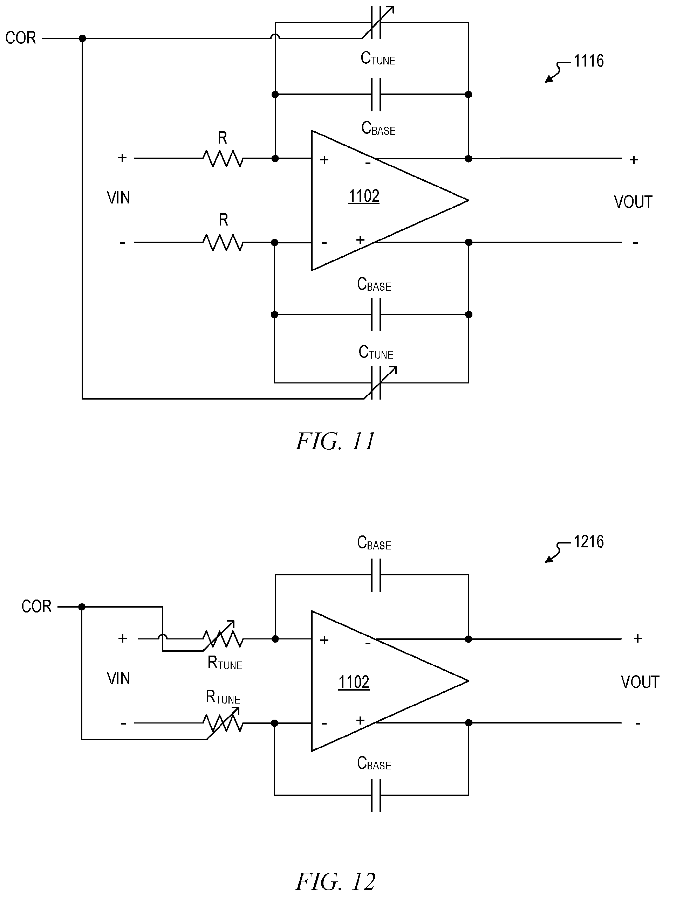

FIG. 11 is a schematic diagram of the integrator 1116 implemented according to one embodiment of the present disclosure that may be used as the integrator 116 within the loop filter 140. The respective polarities of a differential input signal VIN are provided through a pair of input resistors each having a resistance R to respective inputs of a differential amplifier 1102. The differential amplifier 1102 has a differential output providing respective polarities of a differential output signal VOUT. Feedback circuitry including capacitors C_{BASE} and C_{TUNE} is coupled between both of the input polarities and output polarities of the amplifier 1102. The capacitor C_{BASE} has a fixed capacitance coupled in parallel with the capacitor C_{TUNE} having a variable capacitance that is adjusted by COR. COR may be used to adjust C_{TUNE} for adjusting the overall gain of the integrator 116.

VOUT may be determined according to the following equation (3): $VOUT = \frac{1}{{jω}_{1} R \left({C}_{BASE}+{C}_{TUNE}\right)} VIN$ (3) where VOUT/VIN = ω₁/s (in which "s" denotes the complex frequency domain in which s=jω). The gain ω₁ may be determined according to the following equation (4): ${ω}_{1} = \frac{- 1}{R \left({C}_{BASE}+{C}_{TUNE}\right)}$ (4) In this manner, COR adjusts C_{TUNE} which adjusts the gain ω₁ of the integrator 1116, which in turn adjusts the resonant frequency of the loop filter 140. In addition or in the alternative, the integrator 118 may be configured in substantially the same manner as the integrator 1116 having a capacitor with adjustable capacitance C_{TUNE} adjustable by COR for adjusting the gain ω₂ of the integrator 118.

FIG. 12 is a schematic diagram of the integrator 1216 implemented according to another embodiment of the present disclosure that may be used as either one or both of the integrators 116 and 118 within the loop filter 140. The integrator 1216 is substantially similar to the integrator 1116 except that the C_{TUNE} capacitors are eliminated and the input resistors with resistance R are replaced by input resistors each with adjustable resistance R_{TUNE}. The gain ω₁ or ω₂ (depending upon which integrator 116 or 118 is implemented) is adjusted similar to that described in equation (4) with C_{TUNE} removed (or set to 0) and R replaced by R_{TUNE}.

The illustrated integrators 1116 and 1216 are exemplary only and may be implemented according to a variety of different configurations, and the corresponding gain may be adjusted in a variety of different ways. It is also understood that COR may be used to adjust one or more elements of one or more of the amplifiers 120, 122, or 124 for adjusting amplifier gain and thus the resonant frequency of the loop filter 140. Although not specifically shown, for example, a loop filter may be implemented using one or more inductors in which corresponding inductance(s) may be adjusted. A system and method of calibration of a sigma-delta converter as described herein is not intended to be limited to the manner in which gain of at least one loop filter of the ADC is adjusted. The PRBS sequence is a signal that is typically used for sigma delta modulators and suits the need for the present calibration system and method. It is understood, however, that other types of injection signals having equivalent signal power levels left and right of the optimal frequency Fc in the band F_{PB} may also be used as the injected signal.

FIG. 13 is a simplified block diagram of a bandpass filter 1302 that may be used instead of each of the bandpass filters 402 and 404 according to one embodiment of the present disclosure. The bandpass filter 1302 includes a frequency to phase calculator 1304, a phase rotator (or cordic) 1306, and a lowpass decimation filter 1308. A target frequency signal F_{T} is provided to an input of the frequency to phase calculator 1304, having an output providing a phase rotation signal. An input signal, such as either the DOUT signal or the injected signal (e.g., PRBS), is provided to one input of the phase rotator 1306, having a second input receiving the phase rotation signal, and having an output providing a frequency shifted signal to an input of the lowpass decimation filter 1308. The lowpass decimation filter 1308 has an output providing an OUT signal, which is either the A or B signal provided to a respective input of the correlator 406. In one embodiment, the target frequency signal F_{T} is the center frequency F_{C} which is the target notch frequency.

FIG. 14 is a simplified block diagram of an injection signal generator 1402 generating an injection signal IS that is injected into the sigma delta ADC 102 according to another embodiment of the present disclosure. The injection signal generator 1402 may be provided for configurations in which the PRBS generator 104 is not provided or the PRBS signal is not available. The injection signal generator 1402 receives the target notch frequency F_{N} and generates IS for insertion into the conversion path of the sigma-delta ADC 102, such as via the adders 112, 114, 126 or 128 or the like. The injection signal IS is substantially symmetrical around the target notch frequency F_{N} within a selected frequency passband (e.g., F_{PB}) centered at the target notch frequency. In one embodiment, the injection signal IS may be a pseudo-random signal. In another embodiment, the injection signal IS may be a dual tone signal positioned on either side of the target notch frequency F_{N}.

It is noted that conversion system may be implemented with other types of sigma delta converters with multiple frequency notches. In that case, the correct center frequency for each notch frequency may be set using corresponding bandpass filters so that each notch frequency can be optimized. This can be done in a parallel or in a serial manner, depending on settling time and hardware complexity constraints. The present calibration settles more quickly without the presence of strong signals in the bandpass region of the filter pass band. If there is uncorrelated signal content in the band (for example from the input signal), the correlator may need to average longer to remove the uncorrelated content from the correlated content.

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. For example, variations of positive circuitry or negative circuitry may be used in various embodiments in which the present invention is not limited to specific circuitry polarities, device types or voltage or error levels or the like. For example, circuitry states, such as circuitry low and circuitry high may be reversed depending upon whether the pin or signal is implemented in positive or negative circuitry or the like. In some cases, the circuitry state may be programmable in which the circuitry state may be reversed for a given circuitry function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. A digital conversion system (100), comprising:
a sigma-delta converter (102) having an input (110), having a digital output (132), having a conversion path with an injection input (134), and having a frequency adjust input (138);
a calibration circuitry (106), wherein an output of the calibration circuitry (106) is configured to provide a correction signal (COR) to the frequency adjust input (138) in order to adjust a resonant frequency of a loop filter (140) of the sigma-delta converter (102);
a signal generator (104; 1402) having an output coupled to the injection input (134) of the sigma-delta converter (102), wherein the signal generator (104; 1402) is configured to provide an injection signal (IS) at the injection input (134), wherein the injection signal (IS) is substantially symmetrical around a target notch frequency (F_{N});
a first bandpass filter (402; 1302) having an input coupled to the output of the signal generator (104; 1402) for receiving the injection signal (IS) and having an output, and
a second bandpass filter (404; 1302) having an input coupled to the digital output (132) of the sigma-delta converter (102) and having an output, wherein the first and second bandpass filters (402, 404; 1302) are each configured as a complex filter having a frequency response that is asymmetrical around 0 Hz, wherein the first and second bandpass filters (402, 404; 1302) are configured to perform filtering based on the target notch frequency (F_{N}) of the digital output (132) of the sigma-delta converter (102); wherein the first and second bandpass filters (402, 404; 1302) each have a passband frequency range (F_{PB}) centered at the target notch frequency (F_{N}), wherein the target notch frequency (F_{N}) is predetermined based on operating parameters of the sigma-delta converter (102), wherein the loop filter (140) is configured to provide a resonant frequency having a notch at the target notch frequency (F_{N}), wherein the target notch frequency (F_{N}) is at or as close as possible to a center frequency (F_{C}) of the passband frequency range (F_{PB}) of the bandpass filters (402, 404; 1302);
a correlator (406) having a first input coupled to the output (A) of the first bandpass filter (402; 1302), having a second input coupled to the output (B) of the second bandpass filter (404; 1302), and having an output configured to provide an error signal (ERR), wherein the correlator (406) comprises:
a complex conjugate block (502) having an input coupled to the output of either one of the first and second bandpass filters and having an output;
a multiplier (504) configured to multiply the output of the complex conjugate block (502) with the output of another one of the first and second bandpass filters (402, 404; 1302) to provide a product; and
a mean calculator (506) configured to calculate the mean of the product and that provides the mean of the product as the error signal (ERR), wherein the complex conjugate block (502) is configured to be applied to either one of the outputs of the bandpass filters (402, 404; 1302), wherein one of the filtered signals is flipped in the frequency domain, so that the product is essentially zero when the filtered signals are equal or substantially equal; and
a loop controller (408; 708) having an input coupled to the output of the correlator (406) for receiving the error signal (ERR) and having an output coupled to the frequency adjust input (138) of the sigma-delta converter (102).

2. The digital conversion system (100) of claim 1 , wherein the first and second bandpass filters (402, 404; 1302) each comprise:
a frequency to phase calculator (1304) having an input for receiving the target notch frequency (F_{N}) and having an output for providing a phase rotation signal;
a phase rotator (1306) having a first input for receiving either one of the injection signal (IS) and the digital output of the sigma-delta converter (102) and having an output for providing a frequency shifted signal; and
a lowpass decimation filter (1308) having an input receiving the frequency shifted signal and having an output, wherein a target frequency signal (F_{T}) is provided to an input of the frequency to phase calculator (1304) having an output providing a phase rotation signal, wherein the phase rotation signal is provided to a second input of the phase rotator (1306), wherein a frequency shifted signal of the phase rotator (1306) is provided to an input of the lowpass decimation filter (1308), wherein the lowpass decimation filter (1308) has an output providing an output signal (OUT) which is provided to a respective input of the correlator (406).

3. The digital conversion system (100) of any of claims 1 or 2, wherein the loop filter (140) is configured to have a resonant frequency that is adjusted by the correction signal (COR).

4. The digital conversion system (100) of any of claims 1 to 3, wherein the loop filter (140) has at least one adjustable capacitor (C_{TUNE}) having a capacitance that is adjusted by the correction signal (COR).

5. The digital conversion system (100) of any of claims 1 to 4, wherein the loop filter (140) has at least one adjustable resistor (R_{TUNE}) having a resistance that is adjusted by the correction signal (COR).

6. The digital conversion system (100) of any of claims 1 to 5, wherein the first and second bandpass filters (402, 404; 1302) are substantially identical in which each is configured to only pass a part of a positive frequency band.

7. The digital conversion system (100) of any of claims 1 to 6, wherein the signal generator (104) comprises a pseudo random bit stream generator configured to provide a PRBS signal as the pseudo random signal, and wherein the PRBS signal is provided as a dither signal to the injection input (134) of the sigma-delta converter (102).

8. The digital conversion system (100) of any of claims 1 to 7, wherein the sigma-delta converter (102) comprises an analog to digital sigma-delta converter configured for receiving an analog signal and for providing a single bit output.

9. The digital conversion system (100) of any of claims 1 to 8, wherein the loop controller (408) comprises:
a gain block (602) having an input coupled to the output of the correlator for receiving the error signal and having an output providing an amplified error signal;
an integrator (604; 1116; 1216) having an input coupled to the gain block (602) for receiving the amplified error signal and having an output providing an integrated signal; and
a converter (606) that converts the integrated signal into a correction signal provided to the frequency adjust input of the sigma-delta converter (102).

10. The digital conversion system (100) of any of claims 1 to 8, wherein the loop controller (708) comprises:
a least-mean square block (704) having an input coupled to the output of the correlator for receiving the error signal and having an output for providing a least-mean square signal; and
a converter (706) configured to convert the least-mean square signal into a correction signal provided to the frequency adjust input of the sigma-delta converter.

11. A method of digital conversion, comprising:
converting an input signal with a sigma-delta converter (102) to provide a digital output signal (DOUT);
injecting an injection signal (IS) into a conversion path of the sigma-delta converter (102), wherein the injection signal (IS) has substantially frequency-symmetrical power around a target notch frequency (F_{N});
bandpass filtering the injection signal (IS) with a complex filter having a frequency response that is asymmetrical around 0 Hz, to provide a filtered random signal (A);
bandpass filtering the digital output signal (DOUT) of the sigma-delta converter (102) with a complex filter having a frequency response that is asymmetrical around 0 Hz, to provide a filtered output signal (B) wherein the bandpass filtering the injection signal (IS) and the bandpass filtering the digital output signal (DOUT) are performed based on the target notch frequency (FN) of the digital output signal (DOUT) of the sigma-delta converter (102), and each comprise bandpass filtering with a center frequency (FC) at the target notch frequency (FN)
correlating the filtered random signal (A) with the filtered output signal (B) to provide an error signal (ERR), wherein the correlating comprises:
taking a complex conjugate of either one of the injection signal (IS) and the digital output signal to provide a conjugate signal;
multiplying the conjugate signal with the another one of the injection signal and the digital output signal to provide a product signal; and determining a mean value of the product signal; and
adjusting a resonant frequency of the sigma-delta converter (102) based on the error signal (ERR) so that the digital output signal (DOUT) has a target notch frequency (F_{N}).

## Patentansprüche

1. Digitales Umwandlungssystem (100), Folgendes umfassend:
einen Sigma-Delta-Wandler (102), der einen Eingang (110) aufweist, einen digitalen Ausgang (132) aufweist, einen Umwandlungspfad mit einem Injektionseingang (134) aufweist und einen Frequenzjustierungseingang (138) aufweist;
eine Kalibrierungsschaltung (106), wobei ein Ausgang der Kalibrierungsschaltung (106) dazu ausgelegt ist, dem Frequenzjustierungseingang (138) ein Korrektursignal (COR) bereitzustellen, um eine Resonanzfrequenz eines Schleifenfilters (140) des Sigma-Delta-Wandlers (102) zu justieren;
einen Signalgenerator (104; 1402), der einen Ausgang aufweist, der mit dem Injektionseingang (134) des Sigma-Delta-Wandlers (102) gekoppelt ist, wobei der Signalgenerator (104; 1402) dazu ausgelegt ist, ein Injektionssignal (IS) an dem Injektionseingang (134) bereitzustellen, wobei das Injektionssignal (IS) im Wesentlichen symmetrisch um eine Soll-Kerbfrequenz (F_{N}) herum ist;
ein erstes Bandpassfilter (402; 1302), das einen Eingang aufweist, der mit dem Ausgang des Signalgenerators (104; 1402) gekoppelt ist, um das Injektionssignal (IS) zu empfangen, und das einen Ausgang aufweist, und
ein zweites Bandpassfilter (404; 1302), das einen Eingang aufweist, der mit dem digitalen Ausgang (132) des Sigma-Delta-Wandlers (102) gekoppelt ist, und das einen Ausgang aufweist, wobei das erste und das zweite Bandpassfilter (402, 404; 1302) jeweils als ein komplexes Filter konfiguriert sind, das einen Frequenzgang aufweist, der um 0 Hz herum asymmetrisch ist, wobei das erste und das zweite Bandpassfilter (402, 404; 1302) dazu ausgelegt sind, basierend auf der Soll-Kerbfrequenz (F_{N}) des digitalen Ausgangs (132) des Sigma-Delta-Wandlers (102) ein Filtern durchzuführen, wobei das erste und das zweite Bandpassfilter (402, 404; 1302) jeweils einen Passband-Frequenzbereich (F_{PB}) aufweisen, der auf der Soll-Kerbfrequenz (F_{N}) zentriert ist, wobei die Soll-Kerbfrequenz (F_{N}) basierend auf Betriebsparametern des Sigma-Delta-Wandlers (102) festgelegt ist, wobei das Schleifenfilter (140) dazu ausgelegt ist, eine Resonanzfrequenz bereitzustellen, die bei der Soll-Kerbfrequenz (F_{N}) eine Kerbe aufweist, wobei die Soll-Kerbfrequenz (F_{N}) bei oder so nahe wie möglich bei einer Mittenfrequenz (F_{C}) des Passband-Frequenzbereichs (F_{PB}) der Bandpassfilter (402, 404; 1302) liegt;
einen Korrelator (406), der einen ersten Eingang aufweist, der mit dem Ausgang (A) des ersten Bandpassfilters (402; 1302) gekoppelt ist, der einen zweiten Eingang aufweist, der mit dem Ausgang (B) des zweiten Bandpassfilters (404; 1302) gekoppelt ist, und der einen Ausgang aufweist, der dazu ausgelegt ist, ein Fehlersignal (ERR) bereitzustellen, wobei der Korrelator (406) Folgendes umfasst:
einen Komplex-Konjugierte-Block (502), der einen Eingang aufweist, der mit dem Ausgang von einem des ersten und des zweiten Bandpassfilters gekoppelt ist, und der einen Ausgang aufweist;
einen Multiplikator (504), der dazu ausgelegt ist, den Ausgang des Komplex-Konjugierte-Blocks (502) mit dem Ausgang des anderen des ersten und des zweiten Bandpassfilters (402, 404, 1302) zu multiplizieren, um ein Produkt bereitzustellen; und
einen Mittelwertrechner (506), der dazu ausgelegt ist, den Mittelwert des Produkts zu berechnen und der den Mittelwert des Produkts als das Fehlersignal (ERR) bereitstellt, wobei der Komplex-Konjugierte-Block (502) dazu ausgelegt ist, auf einen der Ausgänge der Bandpassfilter (402, 404; 1302) angewandt zu werden, wobei eines der gefilterten Signale in dem Frequenzbereich umgedreht wird, sodass das Produkt um Wesentlichen Null ist, wenn die gefilterten Signale gleich oder im Wesentlichen gleich sind; und
eine Schleifensteuerung (408; 708), die einen Eingang aufweist, der mit dem Ausgang des Korrelators (406) gekoppelt ist, um das Fehlersignal (ERR) zu empfangen, und der einen Ausgang aufweist, der mit dem Frequenzjustierungseingang (138) des Sigma-Delta-Wandlers (102) gekoppelt ist.

2. Digitales Umwandlungssystem (100) nach Anspruch 1, wobei das erste und das zweite Bandpassfilter (402, 404; 1302) jeweils Folgendes umfassen:
einen Frequenz-Phase-Rechner (1304), der einen Eingang zum Empfangen der Soll-Kerbfrequenz (F_{N}) aufweist und der einen Ausgang zum Bereitstellen eines Phasendrehungssignals aufweist;
einen Phasendreher (1306), der einen ersten Eingang zum Empfangen von einem des Injektionssignals (IS) und des digitalen Ausgangs des Sigma-Delta-Wandlers (102) aufweist und der einen Ausgang zum Bereitstellen eines frequenzverschobenen Signals aufweist; und
ein Tiefpass-Dezimierungsfilter (1308), das einen Eingang aufweist, der das frequenzverschobene Signal empfängt, und das einen Ausgang aufweist, wobei ein Soll-Frequenzsignal (F_{T}) einem Eingang des Frequenz-Phase-Rechners (1304) bereitgestellt wird, der einen Ausgang aufweist, der ein Phasendrehungssignal bereitstellt, wobei das Phasendrehungssignal einem zweiten Eingang des Phasendrehers (1306) bereitgestellt wird, wobei ein frequenzverschobenes Signal des Phasendrehers (1306) einem Eingang des Tiefpass-Dezimierungsfilters (1308) bereitgestellt wird, wobei das Tiefpass-Dezimierungsfilter (1308) einen Ausgang aufweist, der ein Ausgangssignal (OUT) bereitstellt, das einem entsprechenden Eingang des Korrelators (406) bereitgestellt wird.

3. Digitales Umwandlungssystem (100) nach einem der Ansprüche 1 oder 2, wobei das Schleifenfilter (140) dazu ausgelegt ist, eine Resonanzfrequenz aufzuweisen, die durch das Korrektursignal (COR) justiert wird.

4. Digitales Umwandlungssystem (100) nach einem der Ansprüche 1 bis 3, wobei das Schleifenfilter (140) mindestens einen justierbaren Kondensator (C_{TUNE}) aufweist, der eine Kapazität aufweist, die durch das Korrektursignal (COR) justiert wird.

5. Digitales Umwandlungssystem (100) nach einem der Ansprüche 1 bis 4, wobei das Schleifenfilter (140) mindestens einen justierbaren Widerstand (R_{TUNE}) aufweist, der einen Widerstand aufweist, der durch das Korrektursignal (COR) justiert wird.

6. Digitales Umwandlungssystem (100) nach einem der Ansprüche 1 bis 5, wobei das erste und das zweite Bandpassfilter (402, 404; 1302) im Wesentlichen insofern identisch sind, dass jedes dazu ausgelegt ist, nur einen Teil eines positiven Frequenzbandes passieren zu lassen.

7. Digitales Umwandlungssystem (100) nach einem der Ansprüche 1 bis 6, wobei der Signalgenerator (104) einen Generator für einen pseudozufälligen Bitstrom umfasst, der dazu ausgelegt ist, ein PRBS-Signal als das pseudozufällige Signal bereitzustellen, und wobei das PRBS-Signal dem Injektionseingang (134) des Sigma-Delta-Wandlers (102) als ein Dither-Signal bereitgestellt wird.

8. Digitales Umwandlungssystem (100) nach einem der Ansprüche 1 bis 7, wobei der Sigma-Delta-Wandler (102) einen Analog-Digital-Sigma-Delta-Wandler umfasst, der dazu ausgelegt ist, ein analoges Signal zu empfangen und einen Einzelbitausgang bereitzustellen.

9. Digitales Umwandlungssystem (100) nach einem der Ansprüche 1 bis 8, wobei die Schleifensteuerung (408) Folgendes umfasst:
einen Verstärkungsblock (602), der einen Eingang aufweist, der mit dem Ausgang des Korrelators gekoppelt ist, um das Fehlersignal zu empfangen, und der einen Ausgang aufweist, der ein verstärktes Fehlersignal bereitstellt;
einen Integrator (604; 1116; 1216), der einen Eingang aufweist, der mit dem Verstärkungsblock (602) gekoppelt ist, um das verstärkte Fehlersignal zu empfangen, und der einen Ausgang aufweist, der ein integriertes Signal bereitstellt; und
einen Wandler (606), der das integrierte Signal in ein Korrektursignal umwandelt, das dem Frequenzjustierungseingang des Sigma-Delta-Wandlers (102) bereitgestellt wird.

10. Digitales Umwandlungssystem (100) nach einem der Ansprüche 1 bis 8, wobei die Schleifensteuerung (708) Folgendes umfasst:
einen LMS(Least-Mean-Square)-Block (704), der einen Eingang aufweist, der mit dem Ausgang des Korrelators gekoppelt ist, um das Fehlersignal zu empfangen, und der einen Ausgang zum Bereitstellen eines LMS-Signals aufweist; und
einen Wandler (706), der dazu ausgelegt ist, das LMS-Signal in ein Korrektursignal umzuwandeln, das dem Frequenzjustierungseingang des Sigma-Delta-Wandlers bereitgestellt wird.

11. Verfahren zur digitalen Umwandlung, Folgendes umfassend:
Umwandeln eines Eingangssignals mit einem Sigma-Delta-Wandler (102), um ein digitales Ausgangssignal (DOUT) bereitzustellen;
Injizieren eines Injektionssignals (IS) in einen Umwandlungspfad des Sigma-Delta-Wandlers (102), wobei das Injektionssignal (IS) eine im Wesentlichen frequenzsymmetrische Leistung um eine Soll-Kerbfrequenz (F_{N}) herum aufweist;
Bandpassfiltern des Injektionssignals (IS) mit einem komplexen Filter, das einen Frequenzgang aufweist, der um 0 Hz herum asymmetrisch ist, um ein gefiltertes zufälliges Signal (A) bereitzustellen;
Bandpassfiltern des digitalen Ausgangssignals (DOUT) des Sigma-Delta-Wandlers (102) mit einem komplexen Filter, das einen Frequenzgang aufweist, der um 0 Hz herum asymmetrisch ist, um ein gefiltertes Ausgangssignal (B) bereitzustellen, wobei das Bandpassfiltern des Injektionssignals (IS) und das Bandpassfiltern des digitalen Ausgangssignals (DOUT) basierend auf der Soll-Kerbfrequenz (FN) des digitalen Ausgangssignals (DOUT) des Sigma-Delta-Wandlers (102) durchgeführt werden und jeweils das Bandpassfiltern mit einer Mittenfrequenz (FC) bei der Soll-Kerbfrequenz (FN) umfassen;
Korrelieren des gefilterten zufälligen Signals (A) mit dem gefilterten Ausgangssignal (B), um ein Fehlersignal (ERR) bereitzustellen, wobei das Korrelieren Folgendes umfasst:
Hernehmen einer komplexen Konjugierten von einem des Injektionssignals (IS) und des digitalen Ausgangssignals, um ein konjugiertes Signal bereitzustellen;
Multiplizieren des konjugierten Signals mit dem anderen des Injektionssignals und des digitalen Ausgangssignals, um ein Produktsignal bereitzustellen; und
Bestimmen eines Mittelwertes des Produktsignals; und
Justieren einer Resonanzfrequenz des Sigma-Delta-Wandlers (102) basierend auf dem Fehlersignal (ERR), sodass das digitale Ausgangssignal (DOUT) eine Soll-Kerbfrequenz (F_{N}) aufweist.

## Revendications

1. Système de conversion numérique (100), comprenant :
un convertisseur sigma-delta (102) pourvu d'une entrée (110), pourvu d'une sortie numérique (132), pourvu d'une voie de conversion dotée d'une entrée d'injection (134), et pourvu d'une entrée d'ajustement de fréquence (138) ; une circuiterie d'étalonnage (106), une sortie de la circuiterie d'étalonnage (106) étant configurée pour fournir un signal de correction (COR) à l'entrée d'ajustement de fréquence (138) dans le but d'ajuster une fréquence de résonance d'un filtre de boucle (140) du convertisseur sigma-delta (102) ;
un générateur de signal (104 ; 1402) pourvu d'une sortie couplée à l'entrée d'injection (134) du convertisseur sigma-delta (102), le générateur de signal (104 ; 1402) étant configuré pour fournir un signal d'injection (IS) sur l'entrée d'injection (134), le signal d'injection (IS) étant sensiblement symétrique autour d'une fréquence cible d'encoche (F_{N}) ;
un premier filtre passe-bande (402 ; 1302) pourvu d'une entrée couplée à la sortie du générateur de signal (104 ; 1402) pour recevoir le signal d'injection (IS) et pourvu d'une sortie, et
un deuxième filtre passe-bande (404 ; 1302) pourvu d'une entrée couplée à la sortie numérique (132) du convertisseur sigma-delta (102) et pourvu d'une sortie, les premier et deuxième filtres passe-bande (402, 404 ; 1302) étant chacun configurés sous la forme d'un filtre complexe présentant une réponse en fréquence qui est asymétrique autour de 0 Hz, les premier et deuxième filtres passe-bande (402, 404 ; 1302) étant configurés pour réaliser un filtrage sur la base de la fréquence cible d'encoche (F_{N}) de la sortie numérique (132) du convertisseur sigma-delta (102) ; les premier et deuxième filtres passe-bande (402, 404 ; 1302) présentant chacun une plage de fréquences dans la bande passante (F_{PB}) centrée sur la fréquence cible d'encoche (F_{N}), la fréquence cible d'encoche (F_{N}) étant prédéterminée sur la base de paramètres de fonctionnement du convertisseur sigma-delta (102), le filtre de boucle (140) étant configuré pour fournir une fréquence de résonance présentant une encoche à la fréquence cible d'encoche (F_{N}), la fréquence cible d'encoche (F_{N}) étant égale à une fréquence centrale (FC) de la plage de fréquences dans la bande passante (F_{PB}) des filtres passe-bande (402, 404 ; 1302), ou aussi proche que possible de celle-ci ; un corrélateur (406) pourvu d'une première entrée couplée à la sortie (A) du premier filtre passe-bande (402 ; 1302), pourvu d'une deuxième entrée couplée à la sortie (B) du deuxième filtre passe-bande (404 ; 1302), et pourvu d'une sortie configurée pour fournir un signal d'erreur (ERR), le corrélateur (406) comprenant :
un bloc de conjugué complexe (502) pourvu d'une entrée couplée à la sortie de l'un quelconque des premier et deuxième filtres passe-bande et pourvu d'une sortie ;
un multiplicateur (504) configuré pour multiplier la sortie du bloc de conjugué complexe (502) par la sortie d'un autre des premier et deuxième filtres passe-bande (402, 404 ; 1302) afin de fournir un produit ; et
un calculateur de moyenne (506) configuré pour calculer la moyenne du produit et qui fournit la moyenne du produit en tant que signal d'erreur (ERR), le bloc de conjugué complexe (502) étant configuré pour être appliqué à l'une ou l'autre des sorties des filtres passe-bande (402, 404 ; 1302), l'un des signaux filtrés étant retourné dans le domaine fréquentiel, de sorte que le produit est essentiellement nul lorsque les signaux filtrés sont égaux ou sensiblement égaux ; et
un contrôleur de boucle (408 ; 708) pourvu d'une entrée couplée à la sortie du corrélateur (406) pour recevoir le signal d'erreur (ERR) et pourvu d'une sortie couplée à l'entrée d'ajustement de fréquence (138) du convertisseur sigma-delta (102).

2. Système de conversion numérique (100) selon la revendication 1, dans lequel les premier et deuxième filtres passe-bande (402, 404 ; 1302) comprennent chacun :
un calculateur fréquence-phase (1304) pourvu d'une entrée pour recevoir la fréquence cible d'encoche (F_{N}) et pourvu d'une sortie pour fournir un signal de rotation de phase ;
un rotateur de phase (1306) pourvu d'une première entrée pour recevoir l'un ou l'autre parmi le signal d'injection (IS) et la sortie numérique du convertisseur sigma-delta (102) et pourvu d'une sortie pour fournir un signal décalé en fréquence ; et
un filtre de décimation passe-bas (1308) pourvu d'une entrée recevant le signal décalé en fréquence et pourvu d'une sortie, un signal de fréquence cible (F_{T}) étant fourni à une entrée du calculateur fréquence-phase (1304) pourvu d'une sortie fournissant un signal de rotation de phase, le signal de rotation de phase étant fourni à une deuxième entrée du rotateur de phase (1306), un signal décalé en fréquence du rotateur de phase (1306) étant fourni à une entrée du filtre de décimation passe-bas (1308), le filtre de décimation passe-bas (1308) étant pourvu d'une sortie fournissant un signal de sortie (OUT) qui est fourni à une entrée respective du corrélateur (406).

3. Système de conversion numérique (100) selon l'une quelconque des revendications 1 ou 2, dans lequel le filtre de boucle (140) est configuré pour présenter une fréquence de résonance qui est ajustée par le signal de correction (COR).

4. Système de conversion numérique (100) selon l'une quelconque des revendications 1 à 3, dans lequel le filtre de boucle (140) est pourvu d'au moins un condensateur ajustable (C_{TUNE}) présentant une capacité qui est ajustée par le signal de correction (COR).

5. Système de conversion numérique (100) selon l'une quelconque des revendications 1 à 4, dans lequel le filtre de boucle (140) est pourvu d'au moins une résistance ajustable (R_{TUNE}) présentant une valeur de résistance qui est ajustée par le signal de correction (COR).

6. Système de conversion numérique (100) selon l'une quelconque des revendications 1 à 5, dans lequel les premier et deuxième filtres passe-bande (402, 404 ; 1302) sont sensiblement identiques, chacun étant configuré pour ne laisser passer qu'une partie d'une bande de fréquences positives.

7. Système de conversion numérique (100) selon l'une quelconque des revendications 1 à 6, dans lequel le générateur de signal (104) comprend un générateur de train de bits pseudo-aléatoire configuré pour fournir un signal PRBS en tant que signal pseudo-aléatoire, et dans lequel le signal PRBS est fourni en tant que signal de dither à l'entrée d'injection (134) du convertisseur sigma-delta (102).

8. Système de conversion numérique (100) selon l'une quelconque des revendications 1 à 7, dans lequel le convertisseur sigma-delta (102) comprend un convertisseur sigma-delta analogique-numérique configuré pour recevoir un signal analogique et pour fournir une sortie monobit.

9. Système de conversion numérique (100) selon l'une quelconque des revendications 1 à 8, dans lequel le contrôleur de boucle (408) comprend :
un bloc de gain (602) pourvu d'une entrée couplée à la sortie du corrélateur pour recevoir le signal d'erreur et pourvu d'une sortie fournissant un signal d'erreur amplifié ;
un intégrateur (604 ; 1116 ; 1216) pourvu d'une entrée couplée au bloc de gain (602) pour recevoir le signal d'erreur amplifié et pourvu d'une sortie fournissant un signal intégré ; et
un convertisseur (606) qui convertit le signal intégré en un signal de correction fourni à l'entrée d'ajustement de fréquence du convertisseur sigma-delta (102).

10. Système de conversion numérique (100) selon l'une quelconque des revendications 1 à 8, dans lequel le contrôleur de boucle (708) comprend :
un bloc de moindres carrés moyens (704) pourvu d'une entrée couplée à la sortie du corrélateur pour recevoir le signal d'erreur et pourvu d'une sortie pour fournir un signal de moindres carrés moyens ; et
un convertisseur (706) configuré pour convertir le signal de moindres carrés moyens en un signal de correction fourni à l'entrée d'ajustement de fréquence du convertisseur sigma-delta.

11. Procédé de conversion numérique, comprenant :
la conversion d'un signal d'entrée au moyen d'un convertisseur sigma-delta (102) afin de fournir un signal de sortie numérique (DOUT) ;
l'injection d'un signal d'injection (IS) dans une voie de conversion du convertisseur sigma-delta (102), le signal d'injection (IS) présentant une puissance sensiblement symétrique en fréquence autour d'une fréquence cible d'encoche (F_{N}) ;
le filtrage passe-bande du signal d'injection (IS) au moyen d'un filtre complexe présentant une réponse en fréquence asymétrique autour de 0 Hz, afin de fournir un signal aléatoire filtré (A) ;
le filtrage passe-bande du signal de sortie numérique (DOUT) du convertisseur sigma-delta (102) au moyen d'un filtre complexe présentant une réponse en fréquence asymétrique autour de 0 Hz, afin de fournir un signal de sortie filtré (B), le filtrage passe-bande du signal d'injection (IS) et le filtrage passe-bande du signal de sortie numérique (DOUT) étant réalisés sur la base de la fréquence cible d'encoche (F_{N}) du signal de sortie numérique (DOUT) du convertisseur sigma-delta (102), et comprenant chacun un filtrage passe-bande avec une fréquence centrale (FC) à la fréquence cible d'encoche (F_{N}) ;
la corrélation du signal aléatoire filtré (A) avec le signal de sortie filtré (B) afin de fournir un signal d'erreur (ERR), la corrélation comprenant :
la prise d'un conjugué complexe de l'un quelconque parmi le signal d'injection (IS) et le signal de sortie numérique afin de fournir un signal conjugué ;
la multiplication du signal conjugué par l'autre parmi le signal d'injection et le signal de sortie numérique afin de fournir un signal de produit ; et
la détermination d'une valeur moyenne du signal de produit ; et
l'ajustement d'une fréquence de résonance du convertisseur sigma-delta (102) sur la base du signal d'erreur (ERR) de sorte que le signal de sortie numérique (DOUT) présente une fréquence cible d'encoche (F_{N}).
